# EUROPÄISCHE PATENTSCHRIFT

(11) **EP 4 490 470 B1**
(45) Veröffentlichungstag und Bekanntmachung des Hinweises auf die Patenterteilung: **11.11.2026**
(21) Anmeldenummer: 23712826.9
(22) Anmeldetag: 15.03.2023
(51) Int. Cl.: G01D 5/244

(54) **VERFAHREN ZUR HERSTELLUNG EINES WINKELLAGEGEBERS**
METHOD FOR PRODUCING AN ANGULAR POSITION SENSOR
PROCÉDÉ DE PRODUCTION D'UN CAPTEUR DE POSITION ANGULAIRE

(30) Priorität: 07.04.2022 DE 102022203538
(43) Veröffentlichungstag der Anmeldung: 15.01.2025
(73) Patentinhaber: Baumüller Nürnberg GmbH, 90482 Nürnberg (DE)
(72) Erfinder: PIRLING, Johannes, 37581 Bad Gandersheim (DE)
(74) Vertreter: FDST Patentanwälte
(86) Internationale Anmeldenummer: PCT/EP2023/056617
(87) Internationale Veröffentlichungsnummer: WO 2023/194061

(56) Entgegenhaltungen:
- JP-A- S5 892 865
- US-A1- 2008 106 873

## Beschreibung

Die Erfindung betrifft ein Verfahren zur Herstellung eines Winkellagegebers sowie einen Winkellagegeber. Der Winkellagegeber weist jeweils eine Leiterplatte mit einem Hall-Sensor auf.

Bei elektromotorisch angetriebenen Maschinen, wie beispielsweise Werkzeugmaschinen, ist ein Wissen um die aktuelle Phasenlage des Elektromotors für den präzisen Betrieb der Maschine nötig. So ist beispielsweise das genau Dosieren von Kunststoff bei einer Spritzgussmaschine oder der korrekte Druck mittels einer von Papierrollen gespeisten Offsetdruckmaschine lediglich möglich, wenn der aktuelle Winkel des Rotors bzgl. des Stators und/oder die aktuelle Rotationsgeschwindigkeit des Elektromotors bekannt ist. Üblicherweise ist daher an einer Welle des Rotors ein Winkellagegeber angeflanscht.

Der Winkellagegeber ist beispielsweise als Resolver ausgestaltet, sodass eine vergleichsweise präzise Messung des jeweils aktuellen Winkels des Rotors bzgl. des Stators möglich ist. Jedoch sind Herstellungskosten eines derartigen Resolvers vergleichsweise hoch. Bei einer kostengünstigeren Variante umfasst der Winkellagegeber einen Hall-Sensor, der mit einem an dem Rotor drehfest befestigten Magneten wechselwirkt, sodass der Winkel erfasst werden kann. Hierbei sind üblicherweise zwei Hall-Sensoren vorgesehen, die zueinander bezüglich der Rotationsachse des Rotors um 90° versetzt sind. Bei einer Drehung des Rotors wird somit mittels eines der Hall-Sensoren eine als Sinus-Spur und mittels des anderen eine als Cosinus-Spur bezeichnete Datenreihe erfasst. Sofern hierbei die beiden Sensoren zueinander sowie bezüglich der Rotationsachse nicht exakt ausgerichtet sind, entsprechen die Daten rein nicht einem tatsächlichen Sinus bzw. Kosinus, weswegen eine hiermit ermittelte Winkellage nicht exakt ist. Daher ist zunächst ein vergleichsweise zeitaufwendiges Kalibrieren des Winkellagegebers erforderlich.

Wie beiden Hall-Sensoren sind beispielsweise diskret zueinander aufgebaut. Zur vereinfachten Montage jedoch sind auch Chips bekannt, die die beiden Hall-Sensoren umfassen. Hierbei sind die beiden Hall-Sensoren auf dem Substrat des Chips exakt zueinander ausgerichtet. Jedoch ist ein exaktes Positionieren der Leiterplatten, an der der Chip üblicherweise befestigt ist, innerhalb eines Gehäuses des Winkellagegebers erforderlich. Hierfür ist das Gehäuse meist mehrteilig aufgebaut, sodass eine Feinjustage der Leiterplatte bezüglich der einzelnen Bauteile des Gehäuses möglich ist.

Aus US 2008/106873 A1 ist ein Montageaufbau mit einem Gehäuse, mit einem an dem Gehäuse montiertes elektronisches Bauteil, mit einem an dem Gehäuse aufrecht angeordneten nadelförmigen Anschluss, mit einer Schalttafel mit einem Montagedurchgangsloch, in das der nadelförmige Anschluss eingeführt ist, und mit einem Montagestützelement, das zwischen dem Gehäuse und der Schalttafel positioniert ist und an dem Gehäuse durch die Schalttafel befestigt ist. **In** dem Montageaufbau weist das Montagestützelement ein Durchgangsloch für ein Positionieren des nadelförmigen Anschlusses und eine geneigte Führungsfläche auf, die fortlaufend zu dem Durchgangsloch ausgebildet ist, um ein distales Ende des nadelförmigen Anschlusses in das Durchgangsloch zu führen.

Der Erfindung liegt die Aufgabe zugrunde, ein besonders geeignetes Verfahren zur Herstellung eines Winkellagegebers sowie einen besonders geeigneten Winkellagegeber anzugeben, wobei vorteilhafterweise Herstellungskosten des Winkellagegebers und/oder ein Ausschuss reduziert sind, und wobei geeigneterweise eine Qualität und/oder Robustheit erhöht ist.

Hinsichtlich des Verfahrens wird diese Aufgabe durch die Merkmale des Anspruchs 1 und hinsichtlich des Winkellagegebers durch die Merkmale des Anspruchs 5 erfindungsgemäß gelöst. Vorteilhafte Weiterbildungen und Ausgestaltungen sind Gegenstand der jeweiligen Unteransprüche.

Das Verfahren dient der Herstellung eines Winkellagegebers. Der Winkellagegeber ist insbesondere ein Sensor zum Erfassen eines Drehwinkels oder dessen Änderung an einer Welle relativ zu einem feststehenden Teil. Hierfür weist der Winkellagegeber insbesondere die Welle auf, die beispielsweise mittels eines Lagers drehbar gelagert ist. Alternativ hierzu ist das Lager kein Bestandteil des Winkellagegebers, und die Welle ist beispielsweise direkt an einem Rotor einer weiteren Maschine befestigt, deren Drehwinkel bestimmt werden soll. Hierbei ist der Rotor mittels eines Lagers der weiteren Maschine zweckmäßigerweise drehbar gelagert. **In** einer weiteren Alternative ist die Welle ebenfalls ein Bestandteil der weiteren Maschine. Bei allen Varianten ist insbesondere der feststehende Teil jeweils ein Bestandteil des Winkellagegebers. Der feststehende Teil ist dabei im Montagezustand zweckmäßigerweise an der weiteren Maschine befestigt.

Die weitere Maschine ist zweckmäßigerweise eine elektrische Maschine, wie zum Beispiel ein Generator oder bevorzugt ein Elektromotor. Vorzugsweise ist hierbei der Winkellagegeber oder zumindest der etwaige feststehende Teil an einem Lagerschild der elektrischen Maschine befestigt. Die elektrische Maschine ist beispielsweise ein Bestandteil eines Kraftfahrzeugs, wie eines Nutzkraftwagens oder Personenkraftwagens (Pkw). **In** einer weiteren Alternative ist das Kraftfahrzeug beispielsweise ein Baustellenfahrzeug oder ein landwirtschaftliches Gerät. Besonders bevorzugt jedoch ist die elektrische Maschine ein Bestandteil einer Industrieanlage und somit stationär ausgestaltet. Hierbei wird zum Beispiel bei Betrieb mittels der elektrischen Maschine ein Werkstück bearbeitet, bewegt und/oder erstellt. Hierfür wird mittels der elektrischen Maschine insbesondere ein maximaler elektrischer Strom von über 1000 A, 2000 A, 3000 A oder 4000 A getragen oder ist zumindest tragbar.

Bei dem Verfahren wird ein Hall-Sensor in eine Aufnahme eines Montagewerkzeugs eingelegt. Der Hall-Sensor ist an einer Leiterplatte befestigt und insbesondere als Chip ausgestaltet, oder der Chip umfasst den Hall-Sensor. Insbesondere ist der Hall-Sensor als integrierter Schaltkreis (IC) ausgestaltet. Beispielsweise ist der Hall-Sensor ein oberflächenmontierbares Bauteil (SMD) oder zum Beispiel mittels Durchsteckmontage an der Leiterplatte befestigt. Die Leiterplatte ist zweckmäßigerweise aus einem glasfaserverstärkten Epoxidharz gefertigt und weist mehrere Leiterbahnen und/oder Lötpads auf, wobei an zumindest einigen hiervon der Hall-Sensor angelötet oder zumindest befestigt ist. Insbesondere umfasst der etwaige Chip einen weiteren Hall-Sensor, wobei sich die Orientierung der beiden Hall-Sensoren zueinander unterscheiden und diese beispielsweise 90° bezüglich einer Achse verdreht sind, die senkrecht zur Leiterplatte ist.

Insbesondere ist der Hall-Sensor oder zumindest Chip, konzentrisch zu einer Rotationsachse des Winkellagegebers angeordnet, die insbesondere senkrecht zur Leiterplatte ist, die beispielsweise im Wesentlichen rund ausgestaltet ist. Hierbei reicht die Rotationsachse vorzugsweise durch das Zentrum der Leiterplatte.

Zusammenfassend ist mittels des Montagewerkzeugs die Aufnahme bereitgestellt, mittels derer die Position des Hall-Sensors vorgegeben wird. Insbesondere ist hierbei eine Spielpassung zwischen dem Hall-Sensor und der Aufnahme geschaffen, wobei zum Beispiel die Aufnahme exakt den Außenabmessungen des Hall-Sensors bzw. des den Hall-Sensor aufweisenden Chips entspricht. Alternativ hierzu ist zum Beispiel ein Übermaß vorhanden, wobei das Übermaß zweckmäßigerweise geringer als 0,1 mm ist. Bevorzugt sind auch Bereiche der Aufnahme vorhanden, die einen größeren Abstand zu dem Hall-Sensor/Chip aufweisen, sodass ein Einführen erleichtert ist. Insbesondere ist der Hall-Sensor bzw. der den Hall -Sensor bereitstellenden Chip im Wesentlichen quaderförmig, wobei die Aufnahme ebenfalls quaderförmig ist. Bevorzugt sind die Ecken der Aufnahme ausgestellt, sodass ein Einführen erleichtert ist. Hierbei ist dennoch mittels der Seitenkanten der Aufnahme eine vergleichsweise genaue Positionierung des Hall-Sensors innerhalb der Aufnahme ermöglicht. Vorzugsweise sind die Außenkanten der Aufnahme angefast, was ein Einführen des Hall-Sensors in die Aufnahme weiter erleichtert.

Beispielsweise ist die Leiterplatte bei Beginn des Verfahrens bereits hergestellt. Alternativ hierzu umfasst das Verfahren einen weiteren, vorhergehenden Arbeitsschritt, bei dem die Leiterplatte gefertigt wird, wobei insbesondere auch der Hall-Sensor an der Leiterplatte befestigt wird, vorzugsweise mittels Lötens.

Nachfolgend wird ein Gehäuse um die Leiterplatte herum angeordnet. Insbesondere wird das Gehäuse über die Leiterplatte gestülpt, sodass die Leiterplatte von dem Gehäuse zumindest teilweise umgeben ist. Vorzugsweise ist die Leiterplatte vollständig mittels des Montagewerkzeugs und des Gehäuses umgeben. Das Gehäuse wird an dem Montagewerkzeug, also mittels des Montagewerkzeugs, ausgerichtet, wofür insbesondere eine Ausrichtvorrichtung des Montagewerkzeugs verwendet wird. Nachfolgend wird die Leiterplatte an dem Gehäuse befestigt. Mit anderen Worten wird die Position der Leiterplatte bezüglich des Gehäuses stabilisiert, wobei die beiden Position zueinander mittels des Montagewerkzeugs vorgegeben ist. Zum Beispiel erfolgt das Befestigen mittels eines weiteren Bauteils, insbesondere eines Befestigungsmittels, oder stoffschlüssig, beispielsweise mittels eines Klebstoffs. Alternativ hierzu wird zumindest teilweise das Gehäuse und/oder die Leiterplatte angeschmolzen, sodass sich eine stoffschlüssige Verbindung zwischen diesen ergibt.

Aufgrund des Verfahrens ist es somit lediglich erforderlich, dass das Montagewerkzeug vergleichsweise genau gefertigt ist. Zumindest jedoch ist es erforderlich, die Position der Aufnahme bezüglich des zum Ausrichten des verwendeten Bestandteils des Montagewerkzeugs mit vergleichsweise geringen Toleranzen behaftet zu fertigen, wohingegen die restlichen Bestandteile des Montagewerk ebenfalls vergrößerte Fertigungstoleranzen aufweisen können. Dennoch wird stets der Hall-Sensor bezüglich des Gehäuses vergleichsweise genau ausgerichtet, und etwaige Toleranzen bei der Befestigung des Hall-Sensors an der Leiterplatte und/oder Fertigungstoleranzen der Leiterplatte führen nicht zu einer veränderten Positionierung des Hall-Sensors bezüglich des Gehäuses.

Das Gehäuse ist insbesondere aus einem Aluminium, wie reinem Aluminium oder einer Aluminiumlegierung erstellt, beispielsweise mittels eines Druckgussverfahrens. Somit sind Herstellungskosten des Gehäuses reduziert. Im Montagezustand ist das Gehäuse üblicherweise an einem weiteren Bauteil einer etwaigen (weiteren) Maschine befestigt, deren Winkellage mittels des Winkellagegebers erfasst werden soll, beispielsweise eines etwaigen Lagerschilds. Da das Gehäuse bezüglich der etwaigen Maschine vergleichsweise genau ausgerichtet ist, ist auch der Hall-Sender bezüglich der etwaigen Maschine vergleichsweise genau gerichtet. Somit ist eine Qualität beim Ermitteln der Winkellage mittels des Winkellagegebers erhöht, und eine Kalibrierung ist im Wesentlichen nicht erforderlich. Somit ist eine Herstellungszeit verkürzt und folglich auch Herstellungskosten. Zudem können bei der Leiterplatte sowie der Befestigung des Hall-Sensors an der Leiterplatte vergleichsweise hohe Fertigungstoleranzen gewählt werden, weswegen Herstellungskosten ebenfalls verringert sind. Dabei ist mittels des Montagewerkzeugs dennoch stets eine genaue Positionierung des Hall-Sensors bezüglich des Gehäuses gegeben, sodass ein Ausschuss verringert ist. Zudem ist es möglich, das Gehäuse vergleichsweise robust zu fertigen, und es ist nicht erforderlich, eine Möglichkeit für eine Feinjustage vorzusehen. Somit ist eine Robustheit erhöht.

Insbesondere ist das Montagewerkzeug aus einem Edelstahl erstellt, vorzugsweise mittels Fräsen. Auf diese Weise ist eine vergleichsweise präzise Fertigung des Montagewerkzeugs ermöglicht. Hierbei sind die Herstellungskosten und die Herstellungszeit des Montagewerk zwar erhöht, jedoch ist lediglich ein einmaliges Fertigen des Montagewerkzeugs erforderlich, das zur Herstellung einer vergleichsweise großen Anzahl an Winkellagegebern verwendet werden kann.

Beispielsweise weist das Gehäuse einen Zapfen auf, der zum Ausrichten in eine entsprechende Bohrung des Montagewerkzeugs eingeführt wird. Besonders bevorzugt jedoch wird eine Außenkontur des Gehäuses an einer Kante des Montagewerkzeugs ausgerichtet. Mit anderen Worten wirkt die Kante als Ausrichtvorrichtung für das Gehäuse. Die Position des Gehäuses wird mittels dessen Außenkontur bestimmt, sodass auch das Gehäuse ansonsten mit vergleichsweise großen Fertigungstoleranzen gefertigt werden kann, wobei die Position der Außenkante des Gehäuses bezüglich des Hall-Sensors fest vorgegeben ist. Die Montage des Winkellagegebers an der etwaigen (weiteren) Maschine erfolgt durch die Positionierung mittels der Außenkante des Gehäuses, da diese von außen zugänglich ist. Somit wird mittels der Außenkante des Gehäuses auch der Hall-Sensor bezüglich der weiteren Maschine vergleichsweise genau ausgerichtet. Dabei sind zum Ausrichten des Gehäuses keine weiteren Bauteile erforderlich, sodass ein Gewicht des Gehäuses und auch Herstellungskosten reduziert sind.

Beispielweise ist das Gehäuse quaderförmig oder besonders bevorzugt topfförmig ausgestaltet. Insbesondere ist die Kante des Montagewerkzeugs kreisförmig und mittels des Montagewerkzeugs ist insbesondere eine topfförmige Vertiefung als Ausrichtvorrichtung bereitgestellt, deren Begrenzung die Kante bildet, und in die das Gehäuse eingesetzt wird. Somit ist die transversale Ausrichtung des Gehäuses bezüglich des Hall-Sensors mittels des Montagewerkzeugs vorgegeben, jedoch ist es möglich, das Gehäuse bezüglich des Hall-Sensors in eine bestimmte Position zu verdrehen, wobei die Achse, um die das Gehäuse bei der Montage gedreht werden kann, insbesondere der Rotationsachse des Winkellagegebers entspricht, die vorzugsweise durch den Hall-Sensor hindurchragt. Vorzugsweise ist zwischen der Kante, also insbesondere der etwaigen topfförmigen Vertiefung, und der Außenkontur eine Spielpassung erstellt, sodass das Gehäuse bezüglich des Montagewerkzeugs gedreht werden kann, weswegen eine gewünschte Ausrichtung gewählt werden kann.

Beispielsweise wird die Leiterplatte lediglich mittels der Aufnahme stabilisiert, bis diese an dem Gehäuse befestigt wird. Besonders bevorzugt jedoch weist das Montagewerkzeug zusätzliche Stifte auf, auf die die Leiterplatte aufgesetzt wird. Vorzugsweise sind dabei die Stifte zu der Aufnahme und/oder zueinander beabstandet. Mittels der Stifte wird ein Verkippen der Leiterplatte verhindert, weswegen das Einlegen des Hall-Sensors in die Aufnahme erleichtert ist.

Beispielsweise sind die Stifte stumpf ausgestaltet und die Leiterplatte liegt lediglich lose auf diesen auf. Besonders bevorzugt jedoch weist die Leiterplatte entsprechende Löcher auf, durch die ein Teil der Stifte geführt ist, die insbesondere endseitig stufenförmig ausgestaltet sind. Dabei liegt die Leiterplatte auf der Stufe auf, wobei das Freiende der Stifte durch die Leiterplatte hindurchragt. Auf diese Weise wird mittels der Stifte ebenfalls die Position der Leiterplatte teilweise vorgegeben. Hierbei dienen die Stifte lediglich der Grobausrichtung der Leiterplatte, sodass insbesondere das Einlegen des Hall-Sensors in die Aufnahme erleichtert ist. Dabei ist insbesondere zwischen den Stiften und den Löchern vergleichsweise viel Spiel vorhanden, sodass das Ausrichten mittels der Aufnahme erleichtert wird. Beispielsweise sind die Stifte aus dem gleichen Material wie die Aufnahme gefertigt, und das Montagewerkzeug ist beispielsweise einstückig.

Besonders bevorzugt jedoch sind die Stifte aus einem separaten Material gefertigt und beispielsweise an einem Grundkörper des Montagewerkzeugs befestigt, mittels dessen sowohl die Aufnahme als auch der Teil zum Ausrichten des Gehäuses bereitgestellt sind. Somit können die Stifte mit erhöhten Fertigungstoleranzen gefertigt werden, weswegen Herstellungskosten weiter reduziert sind. Auch ist ein Austausch der Stifte, beispielsweise bei einer Beschädigung dieser, möglich. Zudem ist es somit lediglich erforderlich, den Grundkörper mit vergleichsweise geringen Fertigungstoleranzen zu fertigen, was einerseits die Fertigung erleichtert und andererseits die Herstellungskosten für das Montagewerkzeug reduziert.

Die Innenwand des Gehäuses weist eine nach innen vorspringende Verdickung auf. Im Bereich der Verdickung ist somit die Innenwand des Gehäuses ins Innere hinein versetzt, und das Gehäuse weist beispielsweise in dem Bereich der Verdickung eine vergrößerte Wandstärke auf. Die Leiterplatte weist eine korrespondierende Kerbe auf, deren Kontur insbesondere der Kontur der Verdickung entspricht. Geeigneterweise ist die Kerbe abgerundet und beispielsweise halbrund ausgestaltet. Insbesondere wird zum Anordnen des Gehäuses um die Leiterplatte herum die Kerbe entlang der Verdickung bewegt, wobei zwischen diesen vorzugsweise eine Spielpassung erstellt ist. Hierbei wird die Leiterplatte bezüglich des Gehäuses insbesondere entlang einer Richtung bewegt, die parallel zur Rotationsachse des Winkellagegebers ist. Aufgrund der Verdickung und der Kerbe ist somit eine Orientierung der Leiterplatte bezüglich des Gehäuses bei dem Anordnen des Gehäuses um die Leiterplatte herum vorgegebenen. Somit ist ein nachfolgendes Ausrichten des Gehäuses an dem Montagewerkzeug vereinfacht und verkürzt.

Insbesondere weist die Verdickung einen Schlitz auf, der sich zweckmäßigerweise zwischen den beiden Enden der Verdickung befindet, und der insbesondere parallel zur Leiterplatte angeordnet ist. Wenn das Gehäuse an dem Montagewerkzeug ausgerichtet wurde, ist der Schlitz zweckmäßigerweise in einer Ebene mit der Leiterplatte und ist direkt benachbart zu dieser angeordnet. Aufgrund der Kerbe ist dabei zwischen dem Schlitz und dem Rest der Verdickung ein Spalt gegeben, sodass das Anordnen und Ausrichten des Gehäuses aufgrund der Leiterplatte nicht behindert wird.

Nachfolgend wird das Gehäuse bezüglich der Leiterplatte verdreht, wobei die Drehachse insbesondere der Rotationsachse des Winkellagegebers entspricht. Infolgedessen wird die Leiterplatte in den Schlitz der Verdickung hinein bewegt, und das Verdrehen wird insbesondere beendet, wenn die Leiterplatte innerhalb der Verdickung einliegt. Infolgedessen ist die Leiterplatte bezüglich des Gehäuses teilweise stabilisiert und eine Befestigung der Leiterplatte an dem Gehäuse vereinfacht. Vorzugsweise ist zwischen der Leiterplatte und dem Schlitz eine Spielpassung erstellt, sodass das Verdrehen erleichtert ist, ohne dass eine Bewegung des Hall-Sensors innerhalb der Aufnahme erfolgt. Mit anderen Worten bleiben auch bei dem Verdrehen das Gehäuse und der Hall-Sensor zueinander ausgerichtet. Insbesondere ist zwischen dem Schlitz und der Leiterplatte ein Abstand von weniger als 0,2 mm vorhanden, sodass auch mittels des Schlitzes zumindest teilweise die Position des Hall-Sensors vorgegeben ist, wobei dennoch die Leiterplatte mit vergleichsweise hohen Fertigungstoleranzen gefertigt werden kann. Zusammenfassend wird mittels des Schlitzes die Position der Leiterplatte innerhalb des Gehäuses vorgegeben sowie diese damit teilweise abgestützt.

Der Schlitz ist beispielsweise bereits beim Urformen des Gehäuses vorhanden. Alternativ hierzu wird dieser erst nachfolgend in die Verdickung gefräst, was beispielsweise im Rahmen des Verfahrens erfolgt. Vorzugsweise umfasst das Gehäuse zwei derartige Verdickungen, die zueinander bezüglich der Rotationsachse vorzugsweise um einen Winkel zwischen 90° und 180° und geeigneterweise um genau 180° zueinander versetzt sind. Infolgedessen ist ein Verkippen der Leiterplatte bezüglich des Gehäuses mittels der beiden Schlitze verhindert. Alternativ sind mehr Verdickungen vorhanden, die insbesondere drehsymmetrisch bezüglich der Rotationsachse angeordnet sind. Somit ist ein Verkippen der Leiterplatte bezüglich des Gehäuses sicher vermieden. Vorzugsweise ist die Anzahl der Verdickungen gleich drei, sodass ein Gewicht des Winkellagegebers nicht übermäßig erhöht ist. Alternativ hierzu sind noch weitere Verdickungen mit jeweils dem Schlitz vorhanden.

Bevorzugt sind die Stifte vorhanden, mittels derer die Drehbewegung des Gehäuses bezüglich der Leiterplatte begrenzt ist. Hierfür liegen die Stifte insbesondere in entsprechenden Führungen des Gehäuses ein, die insbesondere mittels Ausnahmen in der Innenwand des Gehäuses erstellt sind. Mittels jeder Führung sind dabei zwei Anschläge bereitgestellt. Wenn der zugeordnete Stift an dem einen Anschlag anliegt, ist insbesondere ein Einführen der Leiterplatte in das Gehäuse ermöglicht, und das Gehäuse wird somit entlang der Stifte parallel zur Rotationsachse auf das Montagewerkzeug aufgesetzt. Nachfolgend erfolgt das Verdrehen, bis die Stifte an dem gegenüberliegenden Anschlag der jeweiligen Führung anliegen. Dann liegt auch die Leiterplatte in dem Schlitz ein. Folglich ist auch bei dem Verdrehen kein spezielles Ausmessen oder dergleichen erforderlich, weswegen eine Montage vereinfacht ist.

Beispielsweise wird die Leiterplatte innerhalb des Schlitzes mittels Klebstoffs fixiert. Besonders bevorzugt jedoch wird die Leiterplatte und das Gehäuse mittels einer Schraube verschraubt. Diese wird insbesondere in die Verdickung eingedreht. Hierfür ist die Verdickung insbesondere in dem dem Montagewerkzeug abgewandten Teil hohl ausgestaltet, und von dieser Seite wird insbesondere die Schraube in die Verdickung von außerhalb des Gehäuses eingesetzt. Zweckmäßigerweise weist die Leiterplatte ein entsprechendes Loch auf, durch die die Schraube geführt wird. Somit ist das Einführen der Schraube von der dem Montagewerkzeug abgewandten Seite möglich, weswegen eine Montage vereinfacht ist. Auch ist es auf diese Weise möglich, ein vergleichsweise kostengünstiges Montagewerkzeug zu verwenden.

In den Teil der Verdickung, der dem Montagewerkzeug zugewandt ist, wird insbesondere die Schraube eingedreht. Hierfür weist dieser Teil der Verdickung insbesondere ein entsprechendes Innengewinde auf, oder die Schraube ist gewindeschneidend oder gewindefurchend ausgestaltet. Auf diese Weise ist eine Herstellung des Gehäuses vereinfacht. Infolgedessen ist nachfolgend die Leiterplatte zwischen dem Schraubenkopf und dem Teil der Verdickung gehaltenen und folglich an dem Gehäuse stabilisiert. Mit anderen Worten ist die Leiterplatte zwischen den Schraubenkopf und den Teil der Verdickung geklemmt. Besonders bevorzugt sind die beiden Verdickungen vorhanden, wobei jeder der Verdickungen jeweils eine entsprechende Schraube zugeordnet ist. Somit ist eine Stabilität erhöht.

Beispielsweise umfasst der Winkellagegeber zusätzlich einen Rotor, der insbesondere separat hergestellt wird. Der Rotor weist zweckmäßigerweise einen Permanentmagneten auf, der im Montagezustand mit dem Hall-Sensor wechselwirkt. Beispielsweise ist der Permanentmagnet auf einer Welle des Winkellagegebers befestigt, oder die Welle ist zumindest teilweise mittels des Permanentmagneten gebildet. Insbesondere ist die Welle drehbar um die Rotationsachse gelagert, wofür der Winkellagegeber zweckmäßigerweise ein Lager, wie ein Kugellager aufweist.

Das Montagewerkzeug dient der Durchführung eines Verfahrens zur Herstellung eines Winkellagegebers. Bei dem Verfahren wird ein an einer Leiterplatte befestigter Hall-Sensor in eine Aufnahme des Montagewerkzeugs eingelegt. Zudem wird ein Gehäuse um die Leiterplatte herum angeordnet wird, wobei das Gehäuse an dem Montagewerkzeug ausgerichtet wird. Auch wird die Leiterplatte an dem Gehäuse befestigt. Das Montagewerkzeug ist hierfür geeignet, insbesondere vorgesehen und eingerichtet.

Das Montagewerkzeug weist die Aufnahme für den an der Leiterplatte befestigten Hall-Sensor sowie eine Ausrichtvorrichtung zur Ausrichtung des Gehäuses auf. Beispielweise ist das Montagewerkzeug einstückig aus einem Metall gefertigt, vorzugsweise einem Edelstahl. Insbesondere ist das Montagewerkzeug mittels Fräsens erstellt. Somit ist das Fertigen des Montagewerkzeug mit vergleichsweise geringen Fertigungstoleranzen möglich, sodass ein Ausschuss der mittels dieses Montagewerkzeugs hergestellten Winkellagegebern verringert ist. Zudem ist eine Robustheit erhöht, und das Montagewerkzeug kann zum Herstellen einer Vielzahl derartiger Winkellagegeber herangezogen werden. Beispielsweise ist das Montagewerkzeug einstückig oder zumindest ein Grundkörper des Montagewerkzeug, mittels dessen die Ausrichtvorrichtung und die Aufnahme bereitgestellt ist. Somit ist ein vergleichsweise präzises Fertigen des Montagewerkzeugs möglich, wobei ein nachträgliches Ausrichten der Ausrichtvorrichtung und der Aufnahme nicht erforderlich ist. Ferner ist eine Robustheit erhöht.

Beispielsweise weist das Montagewerkzeug zusätzlich die Stifte auf, die insbesondere in entsprechende Bohrungen des etwaigen Grundkörpers eingesetzt sind. Geeigneterweise ist hierbei eine Presspassung zwischen den Stiften und dem Grundkörper erstellt, sodass ein ungewolltes Ablösen der Stifte unterbunden ist. Die Stifte sind beispielsweise aus einem Edelstahl erstellt, was eine Robustheit erhöht. Vorzugsweise sind drei derartige Stifte vorhanden, die insbesondere drehsymmetrisch bezüglich der Aufnahme angeordnet sind.

Besonders bevorzugt ist die Ausrichtvorrichtung des Montagewerkzeugs eine topfförmige Vertiefung, die insbesondere mittels des (etwaigen) Grundkörpers bereitgestellt ist. Hierbei ist mittels des Rand der topfförmigen Vertiefung vorzugsweise eine Kante gebildet, an der das Gehäuse ausgerichtet werden kann. Aufgrund der topfförmigen Vertiefung ist es dabei möglich, das Gehäuse innerhalb der Vertiefung zu drehen, und beispielsweise nach Art eines Bajonettverschlusses mit der Leiterplatte zu verbinden.

Innerhalb der topfförmigen Vertiefung ist bevorzugt ein Dom angeordnet, vorzugsweise an deren Mittelpunkt, wobei der Dom geeigneterweise konzentrisch zu der Vertiefung angeordnet ist. Mit anderen Worten liegen die beiden Achsen aufeinander. Insbesondere ist die Achse des Doms gleich der Rotationsachse des Winkellagegebers, solange dieser an dem Montagewerkzeug montiert wird. Der Dom ist insbesondere quaderförmig, und mittels dessen Freiende ist die Aufnahme bereitgestellt. Hierfür ist das Freiende insbesondere ausgespart, vorzugsweise rechteckförmig. Die Ecken sind dabei bevorzugt ausgestellt, sodass ein Einsetzen des Hall-Sensors erleichtert ist. Vorzugsweise sind zudem die nach außen gerichteten Kanten angefast, was ein Einsetzen des Hall-Sensors weiter vereinfacht.

Der Winkellagegeber weist ein einstückiges topfförmiges Gehäuse auf, das insbesondere aus einem Aluminium erstellt ist. Vorzugsweise ist das Gehäuse mittels eines Druckgussverfahrens erstellt. Das topfförmige Gehäuse weist somit einen Boden und dem gegenüberliegend eine Öffnung auf, die im Montagezustand vorzugweise zu einer etwaigen weiteren Maschine gerichtet ist, und die mittels eines Bauteils der etwaigen weiteren Maschinen, wie eines Lagerschilds, verschlossen ist. Innerhalb des Gehäuses ist eine Leiterplatte angeordnet, an der ein Hall-Sensor befestigt ist. Der Hall-Sensor ist geeigneterweise auf der dem (Topf-)Boden abgewandten Seite der Leiterplatte angeordnet.

Aufgrund des topfförmigen Gehäuses ist die Leiterplatte vergleichsweise geschützt, und ein Aneinanderfügen separater Bauteile zu dem Gehäuse mit vergleichsweise geringen Fertigungstoleranzen ist nicht erforderlich. Somit ist eine Herstellung vereinfacht und auch Herstellungskosten reduziert. Zusammenfassend ist kein Zusammenführen einzelner Bestandteile zu dem Gehäuse erforderlich, weswegen Herstellungskosten reduziert sind. Zudem ist eine Dichtigkeit erhöht. Auch ist eine Lagerhaltung vereinfacht, da lediglich ein einziges Bauteil für das Gehäuse vorgehalten werden muss.

Insbesondere weist der Winkellagegeber zudem einen Rotor auf, der zum Beispiel einen an einer Welle befestigten Permanentmagneten umfasst. Die Welle ist insbesondere auf Seiten der Öffnung des topfförmigen Gehäuses angeordnet und ragt vorzugsweise teilweise in das Gehäuse. Somit ist eine Kompaktheit erhöht.

Vorzugsweise ist der Winkellagegeber gemäß einem Verfahren hergestellt, bei dem der an der Leiterplatte befestigte Hall-Sensor in eine Aufnahme eines Montagewerkzeugs eingelegt wird, und ein Gehäuse um die Leiterplatte herum angeordnet wird, wobei das Gehäuse an dem Montagewerkzeug ausgerichtet wird. Ferner wird gemäß dem Verfahren die Leiterplatte an dem Gehäuse befestigt.

Die Erfindung betrifft ferner eine Maschine mit einem derartigen Winkellagegeber, insbesondere eine elektrische Maschine, wie einen Elektromotor. Dabei ist die Rotationsachse des Winkellagegebers vorzugsweise gleich der Rotationsachse der elektrischen Maschine, und der Rotor des Winkellagegebers ist insbesondere an einem Rotor der elektrischen Maschine befestigt.

Der Winkellagegeber weist an einer Innenwand des Gehäuses eine nach innen vorspringende Verdickung auf, die einen parallel zur Leiterplatte angeordneten Schlitz aufweist, innerhalb dessen die Leiterplatte einliegt. Somit wird mittels des Schlitzes der Verdickung die Position der Leiterplatte zumindest teilweise vorgegeben. Vorzugsweise weist dabei die Leiterplatte eine Kerbe auf, sodass ein Einführen der Leiterplatte in das Gehäuse möglich ist, wobei die Kerbe entlang der Verdickung bewegt wird. Mittels nachfolgenden Verdrehens wird die Leiterplatte in den Schlitz eingeführt, insbesondere nach Art einer Bajonettverbindung. Infolgedessen ist ein Entfernen der Leiterplatte aus dem Gehäuse lediglich mittels Verdrehens dieser zueinander möglich, weswegen eine Robustheit des Winkellagegebers erhöht ist.

Beispielsweise liegt die Leiterplatte lediglich lose innerhalb des Schlitzes ein oder ist dort zum Beispiel mittels eines Klebstoffs fixiert. Besonders bevorzugt jedoch ist die Verdickung in dem dem Boden des Gehäuses zugewandten Teil des Schlitzes hohl, und mittels dieses Teils der Verdickung ist ein Schraubenkopf einer Schraube aufgenommen. Die Schraube ist in den verbleibenden Teil der Verdickung eingeschraubt, sodass diese durch die Leiterplatte hindurch geführt ist. Hierbei ist die Schraube insbesondere parallel zu der Rotationsachse des Winkellagegebers angeordnet, und die Leiterplatte ist somit zwischen dem verbleibenden Teil der Verdickung, in den die Schraube eingeschraubt ist, und dem Schraubenkopf geklemmt. Somit ist die Leiterplatte verliersicher an dem Gehäuse befestigt, wobei zum Beispiel ein Austausch der Leiterplatte bei einer Beschädigung aufgrund der Schraubverbindung auch weiterhin möglich ist. Vorzugsweise ist die Schraube durch ein Loch der Leiterplatte mit Übermaß geführt, sodass eine Ausrichtung des Hall-Sensors bezüglich des Gehäuses bei dem Verschrauben nicht verändert wird.

Die im Zusammenhang mit dem Verfahren erläuterten Weiterbildungen und Vorteile sind sinngemäß auch auf das Montagewerkzeug / den Winkellagegeber / die elektrische Maschine sowie untereinander zu übertragen und umgekehrt.

Nachfolgend wird ein Ausführungsbeispiel der Erfindung anhand einer Zeichnung näher erläutert. Darin zeigen:
- Fig. 1: in einer Schnittdarstellung entlang einer Rotationsachse einen Winkellagegeber
- Fig. 2: in einer Explosionsdarstellung den Winkellagegeber,
- Fig. 3: ein Verfahren zur Herstellung des Winkellagegebers,
- Fig. 4: perspektivisch ein Montagewerkzeug mit einem Dom,
- Fig. 5: perspektivisch vergrößert den Dom, mittels dessen eine Aufnahme bereitgestellt ist,
- Fig. 6: eine Leiterplatte des Winkellagegebers,
- Fig. 7: perspektivisch die an dem Montagewerkzeug gehaltene Leiterplatte,
- Fig. 8: perspektivisch ein Gehäuse des Winkellagegebers,
- Fig. 9 - 13: jeweils perspektivisch den Winkellagegeber in unterschiedlichen Stadien der Fertigung.

Einander entsprechende Teile sind in allen Figuren mit den gleichen Bezugszeichen versehen.

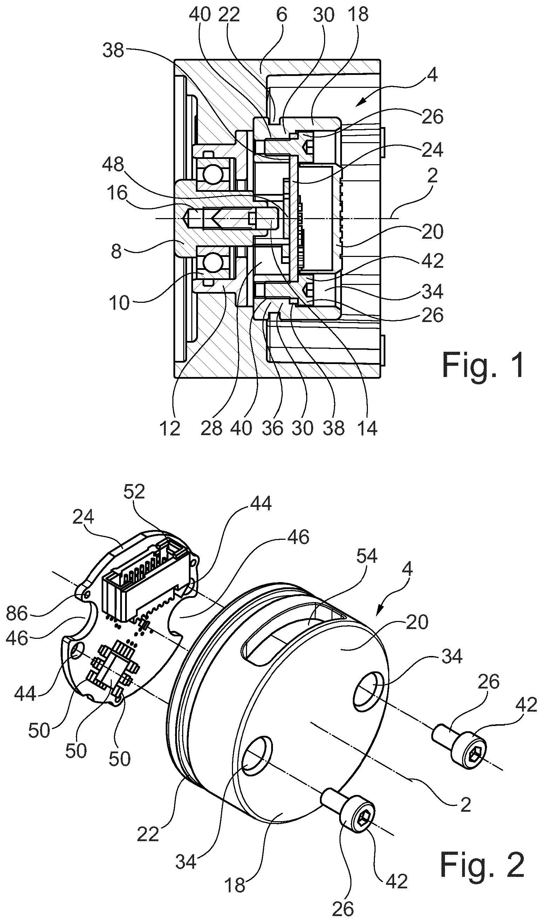

**In** Figur 1 ist in einer Schnittdarstellung entlang einer Rotationsachse 2 und in Figur 2 in einer Explosionsdarstellung ausschnittsweise ein Winkellagegeber 4 dargestellt, der an einem Lagerschild 6 einer elektrischen Maschine, nämlich eines Elektromotors befestigt ist. Der Winkellagegeber 4 weist eine Welle 8 auf, die konzentrisch zur Rotationsachse 2 angeordnet und mittels eines Kugellagers 10 drehbar um die Rotationsachse 2 gelagert ist. Das Kugellager 10 wiederum ist mittels eines hohlzylindrisch ausgestalteten Halteelements 12 des Winkellagegebers 4 umgeben und teilweise daran befestigt. Das Halteelement 12 ist in eine entsprechende Öffnung des Lagerschilds 6 eingesetzt und dort rotationsfest befestigt, wofür zueinander korrespondierende Strukturen ineinander eingreifen.

An dem Lagerschild 6 ist auf der dem Winkellagegeber 4 gegenüberliegenden Seite ein Gehäuse der elektrischen Maschine befestigt, das somit mittels des Lagerschilds 6 verschlossen ist. Von dem Gehäuse ist hierbei ein Rotor der elektrischen Maschine aufgenommen, der mittels nicht näher dargestellter Lager ebenfalls drehbar um die Rotationsachse 2 gelagert ist. An dem Rotor der elektrischen Maschine ist die Welle 8 drehfest befestigt, und an dem dem Rotor abgewandten Ende ist ein Permanentmagnet 14, der nach Art eines Stifts gefertigt ist, in ein konzentrisch zur Rotationsachse 2 angeordnetes Sackloch 16 der Welle 8 gesetzt und steht über dieses endseitig über. Der Permanentmagnet 14 befindet sich hierbei auf der dem Rotor gegenüberliegenden Seite des Lagerschilds 6.

An dem Lagerschild 6 ist ferner ein Gehäuse 18 des Winkellagegebers 4 drehfest befestigt, das topfförmig und einstückig ausgestaltet ist. Das Gehäuse 18 ist aus einem Aluminium in einem Druckgussverfahrens erstellt und ist konzentrisch zur Rotationsachse 2 angeordnet, sodass ein (Topf-)Boden 20 senkrecht zur Rotationsachse 2 verläuft sowie von dem Lagerschild 6 beabstandet ist. Die Öffnung des topfförmigen Gehäuses 18 ist somit teilweise mittels des Halteelements 2 und des Lagerschilds 6 verschlossen. In das Gehäuse 18, nämlich eine Seitenwand, ist außenseitig eine umlaufende Nut 22 eingebracht, in die ein entsprechendes Befestigungselement des Lagerschilds 6 eingreift.

Innerhalb des Gehäuses 18 ist eine Leiterplatte 24 angeordnet die an dem Gehäuse 18 mittels zweier Schrauben 26 befestigt ist. Hierfür weist eine Innenwand 28 des Gehäuses 18 zwei radial nach innen vorspringende und zueinander um 180° bezüglich der Rotationsachse 2 versetzte Verdickungen 30 auf, die parallel zur Rotationsachse 2 verlaufen. Jede der Verdickungen 30 weist zwei Teile 34, 36 auf, die mittels eines jeweiligen, senkrecht zur Rotationsachse 2 verlaufenden Schlitzes 38 zueinander getrennt sind. Der dem Boden 20 zugewandte Teil 34 ist hohl ausgestaltet. Der verbleibende Teil 36, der dem Lagerschild 6 zugewandt ist, weist ein Innengewinde 40 auf, in das die jeweilige Schraube 26 geschraubt ist, wobei sich der jeweilige Schraubenkopf 42 in dem dem Boden 20 des Gehäuses 18 zugewandten Teil 34 befindet.

Die Leiterplatte 24 ist in den beiden Schlitzen 38 angeordnet und weist für jede der Schrauben 26 ein entsprechendes Loch 44 auf, durch das die jeweilige Schraube 26 geführt ist. Hierbei ist zwischen jedem Loch 44 und der jeweiligen Schraube 26 ein Übermaß vorhanden, sodass die Leiterplatte 24 in unterschiedlichen Positionen bezüglich des Gehäuses 18 montiert werden kann. Im Montagezustand jedoch ist die Leiterplatte 24 zwischen die Schraubenköpfe 42 und die verbleibenden Teile 36 geklemmt, sodass eine Bewegung der Leiterplatte 24 bezüglich des Gehäuses 18 nicht möglich ist.

Benachbart zu jedem der Löcher 44 und in dieselbe Winkelrichtung bezüglich der Rotationsachse 2 zu diesem versetzt weist die Leiterplatte 24 randseitig jeweils eine halbrunde Kerbe 46 auf. Die Abmessungen der Kerben 46 entsprechen jeweils den Außenabmessungen jeder der Verdickungen 30 oder zumindest des verbleibenden Teils 36, und die Kerben 46 dienen der Montage des Winkellagegebers 4.

An der Leiterplatte 24 ist auf der dem Boden 20 abgewandten Seite sowie konzentrisch zur Rotationsachse 2 ein Hall-Sensor 48 befestigt, der als Chip, nämlich als Integrierter Schaltkreis (IC), ausgestaltet ist. Auf der dem Boden 20 zugewandten Seite sind an der Leiterplatte 24 weitere elektrische und/oder elektronische Bauteile 50 sowie ein Stecker 52 befestigt, der mit den elektrischen/elektronischen Bauteil 50 sowie dem Hall-Sensor 48 mittels nicht näher dargestellter Leiterbahnen elektrisch kontaktiert ist. Im Montagezustand ist der Stecker 52 innerhalb einer Steckeröffnung 54 der Seitenwand des Gehäuses 18 positioniert, die mittels des Steckers 52 vollständig abgeschlossen wird. Mit Ausnahme der Steckeröffnung 54 sowie der mittels der Verdickungen 30 bereitgestellten Öffnungen ist das Gehäuse 18 verschlossen ausgestaltet. Im Montagezustand sind sämtliche Öffnungen des Gehäuses 18 verschlossen, sodass ein Eindringen von Fremdpartikeln oder Feuchtigkeit in das Gehäuse 18 verhindert ist, die zu einer Funktionsbeeinträchtigung führen könnten.

Bei Betrieb der elektrischen Maschine wird deren Rotor und folglich auch die Welle 8 des Winkellagegebers 4 um die Rotationsachse 2 rotiert. Somit wird der Permanentmagnet 14 ebenfalls rotiert, was zu einem sich zeitlich verändernden Magnetfeld führt, was mittels des Hall-Sensors 48 erfasst wird. Die damit erfassten Signale werden mittels der elektrischen/elektronischen Bauteile 50 zumindest teilweise ausgewertet und an dem Stecker 52 bereitgestellt. Im Montagezustand ist in den Stecker 52 ein entsprechender Gegenstecker der elektrischen Maschine eingesteckt, wobei anhand der mittels des Steckers 52 bereitgestellten Signalen eine Regelung der elektrischen Maschine erfolgt.

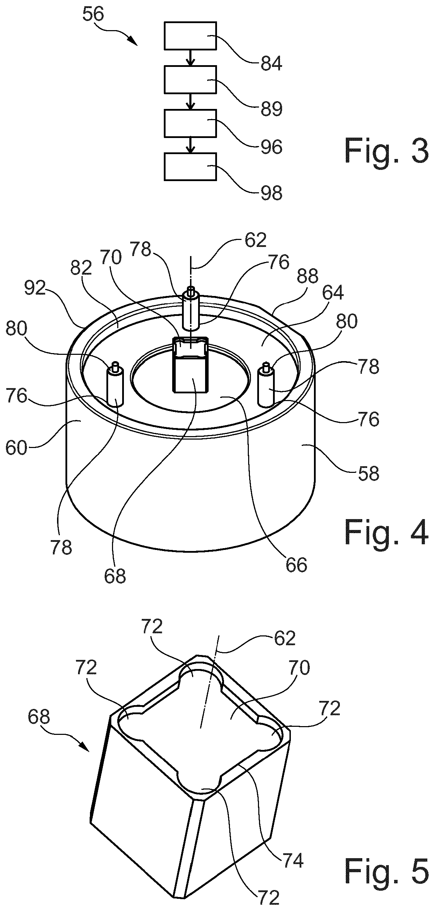

In Figur 3 ist ein Verfahren 56 zur Herstellung des Winkellagegebers 4 dargestellt. Bei dem Verfahren 56 wird ein in Figur 4 perspektivisch gezeigtes Montagewerkzeug 58 verwendet, das einen zylindrisch ausgestalteten Grundkörper 60 aufweist, der sich entlang einer Achse 62 erstreckt. Die Achse 62 fällt mit der Rotationsachse 2 des mittels des Montagewerkzeugs 58 herzustellenden Winkellagegebers 4 während der Montage zusammen.

Eine der Stirnseiten des Grundkörpers 60 weist eine topfförmige Vertiefung 64 auf, die konzentrisch zu der Achse 62 ist. In die Vertiefung 64 ist eine topfförmige weitere Vertiefung 66 eingebracht, deren Durchmesser verringert ist. Innerhalb der weiteren Vertiefung 66 und somit auch innerhalb der Vertiefung 64 ist ein sich entlang der Achse 62 erstreckender quaderförmiger Dom 68 des Grundkörpers 60 angeordnet, der perspektivisch in Figur 5 dargestellt ist. Das der weiteren Vertiefung 66 abgewandte Freiende des Doms 68 weist eine Aufnahme 70 auf, die im Wesentlichen eine quaderförmige Aussparung ist, wobei die Ecken 72 ausgestellt sind, sodass mittels der Ecken 72 jeweils ein Dreiviertelkreis beschrieben ist. Die Kanten 74 der Aufnahme 70 sind angefast, sodass die Aufnahme 70 mit zunehmendem Abstand zu der weiteren Vertiefung 66 geringfügig aufgeweitet ist.

Die Vertiefung 64 weist drei drehsymmetrisch bezüglich der Achse 62 und entlang dieser verlaufende Bohrungen 76 auf, in die mittels einer Presspassung ein jeweiliger Stift 78 eingesetzt ist, der ebenfalls parallel zur Achse 62 angeordnet ist. Die Stifte 78 sind zu dem Grundkörper 60 separate Bauteile und ebenfalls aus einem Edelstahl erstellt. Das dem Grundkörper 60 abgewandte Freiende jedes Stifts 78 weist eine Stufe 80 auf, sodass jeder der Stifte 78 an dem dem Grundkörper 60 abgewandten Freiende verjüngt ausgestaltet ist. Hierbei befinden sich die Stufen 80 im Wesentlichen einer Ebene senkrecht zur Achse 62.

Der Grundkörper 60 ist einstückig aus einem Edelstahl mittels Fräsen erstellt, wobei bei der Fertigung der Aufnahme 70 sowie bei der die Vertiefung 64 nach bezüglich der Achse 62 radial nach außen begrenzenden, umlaufenden Kante 82 die geringstmöglichen Fertigungstoleranzen gewählt werden. Da die Stifte 78 separat zu dem Grundkörper 60 erstellt werden, wird hierbei mittels dieser die Erstellung der Kante 82 nicht behindert.

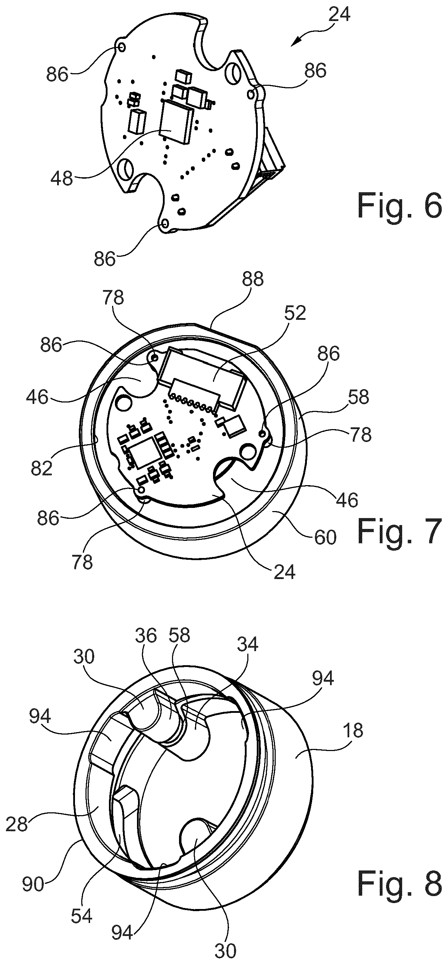

In einem ersten Arbeitsschritt 84 wird die in Figur 6 perspektivisch dargestellte Leiterplatte 24 an dem Montagewerkzeug 58 montiert, wie in Figur 7 dargestellt. Hierfür wird der Hall-Sensor 48 in die Aufnahme 70 des Montagewerkzeug 58 eingelegt. Aufgrund der angefasten Kanten 74 ist das Einlegen des quaderförmigen Hall-Sensors 48 erleichtert. Da die Ecken 72 ausgestellt sind, ist auch bei einem zunächst geringfügig verdrehten Einlegen eine Beschädigung des Hall-Sensors 48 ausgeschlossen. Die Seitenkanten der Aufnahme 70 sind hierbei derart ausgebildet, dass, wenn der Hall-Sensor 48 innerhalb der Aufnahme 70 eingelegt ist, dieser direkt daran anliegt, wobei dennoch ein vergleichsweise einfaches Einführen möglich ist. Jedoch wird mittels der Aufnahme 70 der Hall-Sensor 48 und somit auch die Leiterplatte 24 ausgerichtet. Infolgedessen befindet sich der Hall-Sensor 48 auf der Achse 62 und ist konzentrisch zu dieser angeordnet.

Die Leiterplatte 24 weist drei Positionierlöcher 86 auf, die auf die Stifte 78 aufgesetzt werden. Hierbei liegt, wenn der Hall-Sensor 48 in die Aufnahme 70 eingelegt ist, die Leiterplatte 24 auf den Stufen 80 der Stifte 78 auf, wobei jeder Stift 78, nämlich der verjüngte Teil, durch jeweils eines der Positionierlöcher 86 geführt ist. Hierbei ist zwischen den Stiften 78 und dem jeweiligen Positionierloch 86 ein vergleichsweise großer Spalt vorhanden, sodass die Ausrichtung der Leiterplatte 24 bezüglich des Montagewerkzeugs 58 lediglich mittels des Hall-Sensors 48 sowie der Aufnahme 70 erfolgt, was mittels der Stifte 78 sowie der Positionierlöcher 86 nicht behindert wird. Mittels der Stifte 78 wird jedoch ein Verkippen der Leiterplatte 24 verhindert. Zusammenfassend wird die Leiterplatte 24 auf die Stifte 78 des Montagewerkzeug 58 aufgesetzt.

Zur erleichterten Positionierung zu Beginn des Einlegens weist der Grundkörper 60 an einer der Seiten eine Abflachung 88 auf. Der Stecker 52 weist dabei zur Abflachung 88, wenn der Hall-Sensor 48 in die Aufnahme 70 eingelegt ist.

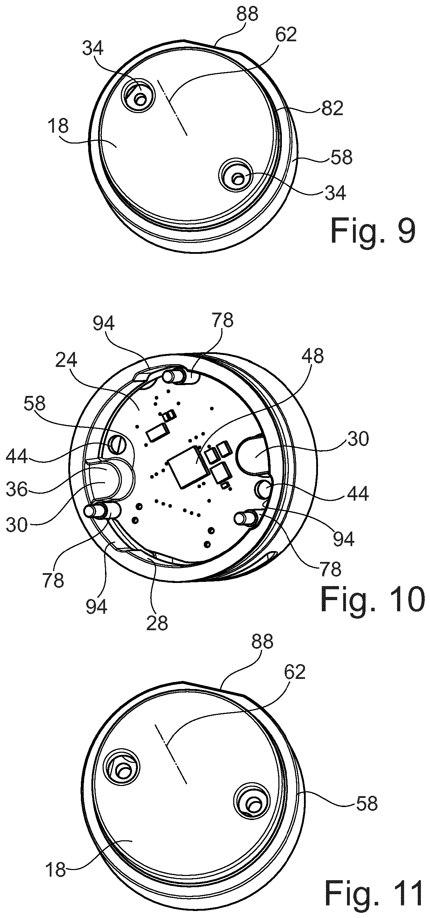

In einem sich anschließenden zweiten Arbeitsschritt 89 wird das perspektivisch in Figur 18 dargestellte Gehäuse 18 auf die Leiterplatten 24 gestülpt, sodass das einstückige Gehäuse 18 um die Leiterplatte 24 herum angeordnet wird, wie in Figur 9 dargestellt. Hierbei liegt eine Außenkontur 90 des Gehäuses 18, die im Bereich der Öffnung des topfförmigen Gehäuses 18 bereitgestellt ist, an der Kante 82 der Vertiefung 64 an, sodass das Gehäuse 18 an dem Montagewerkzeug 58 ausgerichtet wird. Zusammenfassend dient die topfförmige Vertiefung 64 als Ausrichtvorrichtung 92 zur Ausrichtung des Gehäuses 18, wobei die Außenkontur 90 des Gehäuses 18 an der Kante 82 des Montagewerkzeug 58, nämlich der Ausrichtvorrichtung 92, ausgerichtet wird.

Bei dem Positionieren des Gehäuses 18 wird jede der von der Innenwand 28 des Gehäuses 18 nach innen vorspringenden Verdickungen 30 durch jeweils eine der randseitigen Kerben 46 der Leiterplatte 24 geführt. Die Länge der Stifte 78 sowie des Doms 68 sind dabei darauf angepasst, dass, wenn die Leiterplatte 44 auf den Stiften 78 aufliegt und der Hall-Sensor 48 in die Aufnahme 70 eingelegt ist, und wenn das Gehäuse 18 in der Vertiefung 64 eingesetzt ist, die Leiterplatte 24 in einer Ebene mit den Schlitzen 38 der Verdickungen 30 angeordnet ist, wie in Figur 10 von seitens des Montagewerkzeugs 58 gezeigt, wobei der Grundkörper 60 nicht dargestellt ist. Mit anderen Worten wird die Leiterplatte 24 entlang des vollständig verbleibenden Teils 36 der jeweiligen Verdickungen 30 bewegt. In die Innenwand 28 sind drei Führungen 94 eingebracht, die jeweils mittels einer wulstartigen Verringerung der Dicke der Wandstärke des Gehäuses 18 gebildet sind. In jeder der Führungen 94 liegt einer der Stifte 78 ein, wobei bei Anordnen des Gehäuses 18 auf dem Montagewerkzeug 18 jeder Stift 78 an einem tangentialen Ende der jeweiligen Führung 94, also an einem der Anschläge der jeweiligen Führung 94, parallel zur Achse 62 bewegt wird.

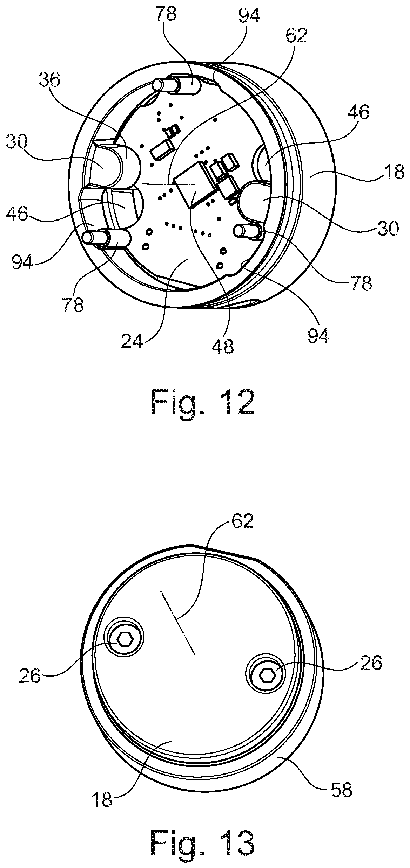

In einem sich anschließenden dritten Arbeitsschritt 96 wird das Gehäuse 18 um die Achse 62 gedreht, sodass der Stecker 52 nicht mehr zur Abflachung 88 weist. Da die Leiterplatte 24 mittels des in der Aufnahme 70 einliegenden Hall-Sensors 48 und der in den Positionierlöchern 86 einliegenden Stifte 78 stabilisiert ist, wird das Gehäuse 18 dabei bezüglich der Leiterplatte 24 verdreht. Infolgedessen gleitet die Leiterplatte 24 in die parallel zur Leiterplatte 24 und senkrecht zur Achse 62 verlaufende Schlitze 38 der Verdickungen 30. Somit befinden sich nachfolgend die Kerben 46 bezüglich der jeweils zugeordneten Verdickung 30 tangential bezüglich der Achse 62 versetzt, wie in Figur 12 von seitens des Montagewerkzeug 58 gezeigt, wobei wiederum der Grundkörper 60 nicht dargestellt ist.

Das Gehäuse 18 wird dabei so lange bezüglich der Leiterplatte 24 und somit auch bezüglich des Montagewerkzeugs 58 verdreht, bis ein weiteres Verdrehen aufgrund der an den gegenüberliegenden Anschlägen der jeweiligen Führung 94 anliegenden Stiften 78 nicht mehr möglich ist. Mit anderen Worten wird mittels der Führungen 94 und der Stifte 78 der Winkel vorgegeben, um den das Gehäuse 18 bezüglich der Leiterplatte 24 verdreht wird. Nach dem Verdrehen befinden sich die Löcher 44, die, wie in Figur 10 dargestellt, beim Einführen der Leiterplatte 24 in das Gehäuse 18 zunächst tangential bezüglich der Verdickungen 30 versetzt waren, zwischen den beiden Teilen 34, 36 der jeweiligen Verdickung 30 in dem jeweiligen Schlitz 38.

In einem sich anschließenden vierten Arbeitsschritt 98 wird in jeden der dem Boden 34 des Gehäuses 18 zugewandten Teil 34 der jeweiligen Verdickung 30 von der dem Montagewerkzeug 58 abgewandten Seite jeweils eine der Schrauben 26 eingesetzt. Jede Schraube 26 wird durch das aufgrund des Verdrehens entsprechend positionierte Loch 44 der Leiterplatte 24 hindurch geführt und in den jeweiligen verbleibenden Teil 36, nämlich das Innengewinde 40, eingedreht. Folglich wird die Leiterplatte 24 zwischen den verbleibenden Teil 36 der Verdickungen 30 und den jeweiligen Schraubenkopf 42 geklemmt, und die Leiterplatte 24 und das Gehäuse 18 werden mittels der Schrauben 26 verschraubt, sodass die Leiterplatte 24 an dem Gehäuse 18 befestigt ist, wie in Figur 13 dargestellt.

Nachfolgend ist das Verfahren 56 beendet, und die Welle 8 sowie der Permanentmagnet 14 als auch das Kugellager 10 und das Halteelemente 12 werden in einem separaten Verfahren gefertigt sowie an dem Gehäuse 18 befestigt. In einer Alternative werden diese Teile in nicht näher dargestellten Arbeitsschritten des Verfahrens 56 montiert.

### Bezugszeichenliste

- 2: Rotationsachse
- 4: Winkellagegeber
- 6: Lagerschild
- 8: Welle
- 10: Kugellager
- 12: Halteelement
- 14: Permanentmagnet
- 16: Sackloch
- 18: Gehäuse
- 20: (Topf-)Boden
- 22: Nut
- 24: Leiterplatte
- 26: Schraube
- 28: Innenwand
- 30: Verdickung
- 34: dem Boden des Gehäuses zugewandter Teil
- 36: verbleibender Teil
- 38: Schlitz
- 40: Innengewinde
- 42: Schraubenkopf
- 44: Loch
- 46: Kerbe
- 48: Hall-Sensor
- 50: elektrische/elektronische Bauteile
- 52: Stecker
- 54: Steckeröffnung
- 56: Verfahren
- 58: Montagewerkzeug
- 60: Grundkörper
- 62: Achse
- 64: Vertiefung
- 66: weitere Vertiefung
- 68: Dom
- 70: Aufnahme
- 72: Ecken
- 74: Kante
- 76: Bohrung
- 78: Stift
- 80: Stufe
- 82: Kante
- 84: erster Arbeitsschritt
- 86: Positionierloch
- 88: Abflachung
- 89: zweiter Arbeitsschritt
- 90: Außenkontur
- 92: Ausrichtvorrichtung
- 94: Führung
- 96: dritter Arbeitsschritt
- 98: vierter Arbeitsschritt

## Patentansprüche

1. Verfahren (56) zur Herstellung eines Winkellagegebers (4), bei welchem
- ein an einer Leiterplatte (24) befestigter Hall-Sensor (48) in eine Aufnahme (70) eines Montagewerkzeugs (58) eingelegt wird,
- ein einstückiges topfförmiges Gehäuse (18) um die Leiterplatte (24) herum angeordnet wird, wobei das Gehäuse (18) an dem Montagewerkzeug (58) ausgerichtet wird, und
- die Leiterplatte (24) an dem Gehäuse (18) befestigt wird, wobei eine an einer Innenwand (28) des Gehäuses (18) nach innen vorspringende Verdickung (30) durch eine randseitige Kerbe (46) der Leiterplatte (24) geführt wird, und wobei anschließend das Gehäuse (18) bezüglich der Leiterplatte (24) derart verdreht wird, dass die Leiterplatte (24) in einem parallel zur Leiterplatte (24) verlaufenden Schlitz (38) der Verdickung (30) einliegt.

2. Verfahren (56) nach Anspruch 1,
**dadurch gekennzeichnet,**
**dass** eine Außenkontur (90) des Gehäuses (18) an einer Kante (82) des Montagewerkzeugs (58) ausgerichtet wird.

3. Verfahren (56) nach Anspruch 1 oder 2,
**dadurch gekennzeichnet,**
**dass** die Leiterplatte (24) auch auf Stifte (78) des Montagewerkzeugs (58) aufgesetzt wird.

4. Verfahren (56) nach einem der Ansprüche 1 bis 3,
**dadurch gekennzeichnet,**
**dass** die Leiterplatte (24) und das Gehäuse (18) mittels einer Schraube (26) verschraubt werden, die in die Verdickung (30) eingedreht wird.

5. Winkellagegeber (4) mit einer in einem einstückigen topfförmigen Gehäuse (18) angeordneten Leiterplatte (24), an der ein Hall-Sensor (48) befestigt ist, wobei an einer Innenwand (28) des Gehäuses (18) eine Verdickung (30) nach innen vorspringt, die einen parallel zur Leiterplatte (24) angeordneten Schlitz (38) aufweist, innerhalb dessen die Leiterplatte (24) einliegt, wobei der Winkellagegeber (4) durch ein Verfahren nach einem der vorherigen Ansprüche hergestellt ist.

6. Winkellagegeber (4) nach Anspruch 5,
**dadurch gekennzeichnet,**
**dass** der bezüglich des Schlitzes (38) dem Boden (20) des Gehäuses (18) zugewandte Teil (34) der Verdickung (30) hohl ist und einen Schraubenkopf (42) einer Schraube (26) aufnimmt, die in den verbleibenden Teil (36) der Verdickung (30) eingeschraubt ist, wobei zwischen dem verbleibenden Teil (36) der Verdickung (30) und dem Schraubenkopf (42) die Leiterplatte (24) geklemmt ist.

## Claims

1. Method (56) for producing an angular position sensor (4), in which
- a Hall sensor (48) fastened to a printed circuit board (24) is inserted into a receptacle (70) of an assembly tool (58),
- a one-piece pot-shaped housing (18) is arranged around the printed circuit board (24), wherein the housing (18) is aligned with the assembly tool (58), and
- the printed circuit board (24) is fastened to the housing (18), wherein
an inwardly projecting thickening (30) on an inner wall (28) of the housing (18) is guided through a notch (46) at the edge of the printed circuit board (24), and wherein the housing (18) is subsequently turned with respect to the printed circuit board (24) in such a way that the printed circuit board (24) lies in a slot (38) of the thickening (30) that runs parallel to the printed circuit board (24).

2. Method (56) according to Claim 1,
**characterized**
**in that** an outer contour (90) of the housing (18) is aligned with an edge (82) of the assembly tool (58).

3. Method (56) according to Claim 1 or 2,
**characterized**
**in that** the printed circuit board (24) is also placed on pins (78) of the assembly tool (58).

4. Method (56) according to one of Claims 1 to 3,
**characterized**
**in that** the printed circuit board (24) and the housing (18) are screwed by means of a screw (26), which is screwed into the thickening (30).

5. Angular position sensor (4) with a printed circuit board (24), which is arranged in a one-piece pot-shaped housing (18) and to which a Hall sensor (48) is fastened, wherein projecting inwards from an inner wall (28) of the housing (18) is a thickening (30), which has a slot (38) which is arranged parallel to the printed circuit board (24) and within which the printed circuit board (24) lies, wherein the angular position sensor (4) is produced by a method according to one of the preceding claims.

6. Angular position sensor (4) according to Claim 5,
**characterized**
**in that** the part (34) of the thickening (30) that is facing the base (20) of the housing (18) with respect to the slot (38) is hollow and receives a screw head (42) of a screw (26) which is screwed into the remaining part (36) of the thickening (30), wherein the printed circuit board (24) is clamped between the remaining part (36) of the thickening (30) and the screw head (42).

## Revendications

1. Procédé (56) de fabrication d'un capteur de position angulaire (4), dans lequel
- un capteur à effet Hall (48) fixé sur une carte de circuits imprimés (24) est inséré dans un réceptacle (70) d'un outil d'assemblage (58),
- un boîtier (18) en forme de pot monobloc est disposé tout autour de la carte de circuits imprimés (24), le boîtier (18) étant aligné avec l'outil d'assemblage (58), et
- la carte de circuits imprimés (24) est fixée sur le boîtier (18),
un épaississement (30) faisant saillie vers l'intérieur sur une paroi intérieure (28) du boîtier (18) étant guidé à travers une encoche (46) côté bord de la carte de circuits imprimés (24), puis le boîtier (18) étant tourné par rapport à la carte de circuits imprimés (24) de telle manière que la carte de circuits imprimés (24) est placée dans une fente (38) de l'épaississement (30) s'étendant parallèlement à la carte de circuits imprimés (24).

2. Procédé (56) selon la revendication 1,
**caractérisé en ce**
**qu'**un contour extérieur (90) du boîtier (18) est aligné avec une arête (82) de l'outil d'assemblage (58).

3. Procédé (56) selon la revendication 1 ou 2,
**caractérisé en ce**
**que** la carte de circuits imprimés (24) est posée également sur des broches (78) de l'outil d'assemblage (58).

4. Procédé (56) selon l'une des revendications 1 à 3,
**caractérisé en ce**
**que** la carte de circuits imprimés (24) et le boîtier (18) sont vissés au moyen d'une vis (26) qui est vissée dans l'épaississement (30).

5. Capteur de position angulaire (4) avec une carte de circuits imprimés (24) disposée dans un boîtier (18) en forme de pot monobloc, sur laquelle est fixé un capteur à effet Hall (48), un épaississement (30) faisant saillie vers l'intérieur sur une paroi intérieure (28) du boîtier (18), qui comporte une fente (38) disposée parallèlement à la carte de circuits imprimés (24), à l'intérieur de laquelle est placée la carte de circuits imprimés (24), le capteur de position angulaire (4) étant fabriqué par un procédé selon l'une des revendications précédentes.

6. Capteur de position angulaire (4) selon la revendication 5,
**caractérisé en ce**
**que** la partie (34) de l'épaississement (30) tournée vers le fond (20) du boîtier (18) par rapport à la fente (38) est creuse et loge une tête de vis (42) d'une vis (26) qui est vissée dans la partie restante (36) de l'épaississement (30), la carte de circuits imprimés (24) étant serrée entre la partie restante (36) de l'épaississement (30) et la tête de vis (42).
